(19) Europäisches Patentamt / European Patent Office / Office européen des brevets

(11) **EP 1 320 190 B1**

(12) **FASCICULE DE BREVET EUROPEEN**

(45) Date de publication et mention
de la délivrance du brevet:
**10.09.2008 Bulletin 2008/37**

(51) Int Cl.:
***H03F 1/32*** *(2006.01)*

(21) Numéro de dépôt: **02292889.9**

(22) Date de dépôt: **21.11.2002**

(54) **Linéariseur à prédistorsion à large bande de fréquences**

Breitband- Vorverzerrungslinearisierer

A wideband predistortion linearizer

(84) Etats contractants désignés:
**AT BE BG CH CY CZ DE DK EE ES FI FR GB GR IE IT LI LU MC NL PT SE SK TR**

(30) Priorité: **06.12.2001 FR 0115774**

(43) Date de publication de la demande:
**18.06.2003 Bulletin 2003/25**

(73) Titulaire: **Alcatel Lucent**
**75008 Paris (FR)**

(72) Inventeurs:
• **Villemazet, Jean-François**
**31550 Cintegabelle (FR)**
• **Moroni, Pascal**
**31300 Toulouse (FR)**
• **Cogo, Bernard**
**31850 Montrabe (FR)**

(74) Mandataire: **Esselin, Sophie et al**
**Marks & Clerk France**
**31-33 Avenue Aristide Briand**
**94117 Arcueil Cedex (FR)**

(56) Documents cités:
EP-A- 0 277 636          EP-A- 0 844 732
EP-A- 0 984 509          EP-A- 1 098 435
US-A- 5 999 064          US-B1- 6 255 908

**Description**

L'invention est relative à un linéariseur à pré-distorsion pour amplificateur à large bande de fréquences, notamment dans le domaine des hyperfréquences.

Lorsque les besoins en puissance de signaux électroniques sont importants, on fait appel à un amplificateur que l'on fait fonctionner au voisinage de sa puissance de saturation. On citera ici, à titre d'exemple, les besoins en émission de satellites de télécommunications pour lesquels on utilise souvent des amplificateurs à tube(s) à onde progressive.

Le fonctionnement proche de la saturation entraîne une réponse non linéaire de l'amplificateur. De façon plus précise, quand la puissance d'entrée est sensiblement plus faible que la puissance de saturation, la puissance de sortie est sensiblement proportionnelle à la puissance d'entrée. Par contre, quand la puissance d'entrée se rapproche de la puissance de saturation, le gain diminue, pour prendre la valeur 1 à la saturation. Ce défaut de linéarité se traduit aussi sur la phase du signal de sortie : cette phase est constante quand l'amplificateur fonctionne en dehors de la zone de saturation et, pour certains amplificateurs (notamment ceux à tube à onde progressive), diminue quand la puissance se rapproche de la valeur de saturation.

Pour remédier à cet inconvénient, on utilise couramment, notamment pour les amplificateurs à tube pour lesquels le gain et la phase diminuent quand la puissance d'entrée s'approche de la valeur de saturation, des dispositifs de linéarisation à pré-distorsion. Un tel dispositif est disposé en amont de l'amplificateur ou du tube à linéariser. Il fournit un signal de sortie dont l'amplitude et la phase varient en fonction de la puissance d'entrée d'une manière non linéaire et de façon telle que l'amplitude et la phase du signal de sortie de l'amplificateur varient de façon linéaire en fonction de la puissance du signal à l'entrée du dispositif de pré-distorsion.

De façon plus précise, dans le dispositif de linéarisation, on applique tant au gain qu'à la phase, une pré-distorsion qui garde le gain et la phase constants pour les valeurs de la puissance d'entrée sensiblement inférieures à la puissance de saturation et un gain et une phase qui augmentent quand la puissance d'entrée se rapproche de la puissance de saturation, ce qui permet de compenser la diminution du gain et de la phase de l'amplificateur.

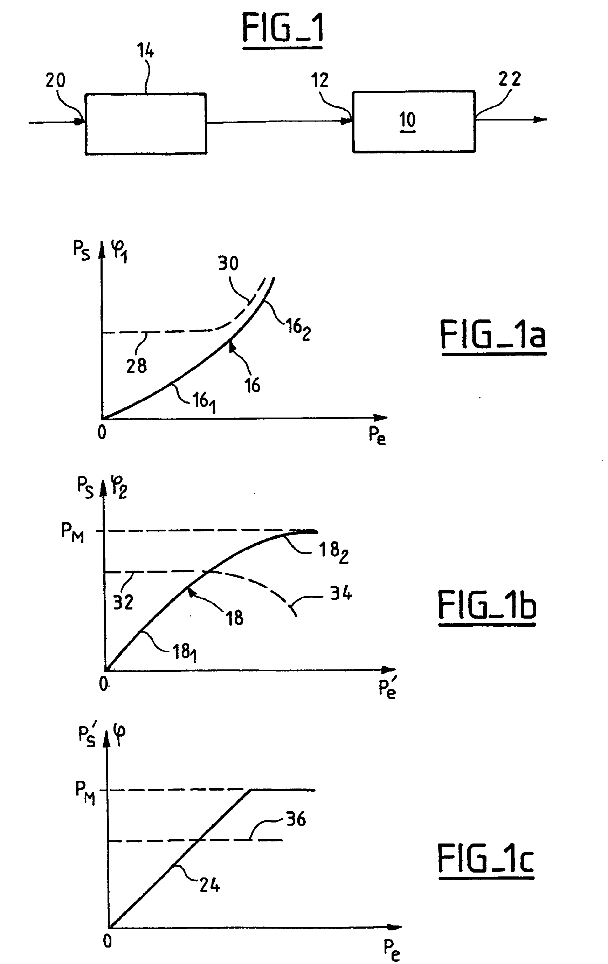

Ce principe est illustré sur la figure 1, où l'on a représenté un amplificateur de puissance 10 à tube destiné, par exemple, à être embarqué à bord d'un engin spatial tel qu'un satellite de façon à alimenter une ou des antennes d'émission (non montrées) d'un système de télécommunications. Le signal à amplifier est appliqué sur l'entrée 12 de cet amplificateur 10 par l'intermédiaire d'un dispositif 14 de linéarisation du type à pré-distorsion.

Sur le diagramme de la figure 1a, on a porté en abscisses, la puissance $P_e$ d'entrée et, en ordonnées, la puissance $P_s$ de sortie. La courbe 16 sur ce diagramme correspond au dispositif 14 de linéarisation. On voit que la courbe 16 présente, pour les faibles puissances d'entrée, une partie linéaire $16_1$ et, pour les valeurs les plus élevées de la puissance d'entrée, une partie non linéaire $16_2$ dont la pente est plus élevée que celle de la partie linéaire $16_1$.

Le diagramme de la figure 1b correspond au fonctionnement de l'amplificateur 10, dans ce cas, à tube à onde progressive. Ce diagramme est analogue à celui de la figure 1a. La courbe 18 présente une première partie $18_1$ linéaire et une seconde partie $18_2$ non-linéaire pour les valeurs les plus élevées de la puissance de sortie $P_S$, quand cette dernière se rapproche de la puissance $P_M$ de saturation. Dans la partie $18_2$, la pente est plus faible que la pente de la partie linéaire $18_1$ et se rapproche de zéro.

Sur le diagramme de la figure 1c, on a montré la relation entre le signal $P_e$ à l'entrée 20 du dispositif 14 et le signal $P'_s$ sur la sortie 22 de l'amplificateur 10. On voit que la courbe de variation de $P'_s$ en fonction de $P_e$ présente, jusqu'à la saturation $P_M$, une variation linéaire 24.

Sur les diagrammes des figures 1a à 1c, on a aussi représenté, en traits interrompus, les variations de la phase φ des signaux de sortie en fonction des puissances $P_e$ ou $P'_e$ des signaux d'entrée. On voit sur la figure 1a que la phase φ1 du signal sur la sortie du dispositif 14 reste constante (partie plate 28) pour les valeurs les plus faibles de la puissance d'entrée $P_e$ et augmente de façon non linéaire (partie 30) pour les puissances d'entrée qui se rapprochent de la puissance de saturation.

On voit sur la figure 1b que la phase $φ_2$ du signal sur la sortie 22 de l'amplificateur 10 est constante pour les plus faibles valeurs de la puissance $P_e'$ sur l'entrée 12 et décroît de façon non linéaire (partie 34) quand cette puissance d'entrée se rapproche de la puissance de saturation.

Sur la figure 1c, on voit que la phase du signal sur la sortie 22 reste constante (droite 36).

Différents types de linéariseurs à prédistorsion ont déjà été étudiés. Une première famille de linéariseurs à prédistorsion est décrite par exemple par le document US-A-4.992.754 de BLAUVELT et al., au nom de ORTEL Corp. (USA). Selon l'enseignement de ce document, le signal utile est appliqué à une ligne à retard, tandis que le signal de correction est élaboré dans une branche parallèle, avec un réglage d'amplitude pour le rendre égal à celui de la non-linéarité du signal amplifié, et un réglage de la phase du signal pour obtenir une opposition de phase par rapport au signal utile qui se propage sur la ligne à retard. Le signal utile et le signal de correction sont additionnés à l'aide d'un combineur ou d'un coupleur hyperfréquence, et ensuite acheminés sur l'entrée de l'amplificateur hyperfréquence de puissance. Les non-linéarités constatées à la sortie de l'étage d'amplification de puissance sont ainsi sensiblement diminuées sinon éliminées.

On peut citer aussi un autre type de linéariseur à prédistorsion connu par exemple par le document US-A-4.068.186 de SATO et al., au nom de KDD (Japon). Ce linéariseur est conçu pour travailler à des hautes fréquences pour pallier les non-linéarités d'un amplificateur du type TOP (tube à ondes progressives) ou klystron. Comme générateur de non-linéarité, SATO et al. enseigne l'utilisation d'un TOP de faible puissance. Ce genre d'amplificateur introduit un léger retard (du à la vitesse finie de propagation d'électrons dans le vide) du signal amplifié par rapport au signal non amplifié. Afin de synchroniser les signaux des voies non-linéaire et linéaire, il faut donc introduire une ligne à retard dans la branche correctrice. Le dispositif de SATO et al. est relativement compliqué du fait qu'il y a deux organes correcteurs en amont et en aval d'un diviseur de puissance et d'un combineur de puissance relié entre eux par deux voies dites linéaire et non-linéaire. La voie linéaire comprend en outre un amplificateur hyperfréquence dont le point de fonctionnement est choisi près de la saturation pour obtenir la génération de non-linéarités qui dépendent de la puissance du signal d'entrée. Afin de pouvoir régler le niveau de sortie du dispositif linéariseur à prédistorsion, sans agir sur le gain de l'amplificateur, un atténuateur variable est situé en sortie de l'amplificateur. La voie non-linéaire comprend un autre organe correcteur de la caractéristique phase-fréquence. Les signaux des deux voies sont appliqués aux deux entrées d'un deuxième coupleur combiner, ou ils sont additionnés (encore avec un décalage de phase θ entre les deux signaux). Ce coupleur peut être par exemple un coupleur hybride 3dB, ce qui introduit encore un déphasage de $\theta = \pi/2$.

Ce dispositif de l'art antérieur comprend donc deux organes correcteurs de la caractéristique non-linéaire amplitude-fréquence, ainsi qu'un organe correcteur de la caractéristique phase-fréquence. Des exemples de réalisation de tels organes correcteurs sont décrits dans le document SATO et al., dont le texte de la description est expressément incorporé par référence dans la présente demande, pour ce qui concerne sa description de réalisations de l'art antérieur.

Les caractéristiques non linéaires de ces organes s'ajoutent à ceux de l'amplificateur hyperfréquence. Les fonctions de transfert de tous ces organes varient de façon disparate en fonction de la fréquence et de l'amplitude des signaux, ou encore en fonction de la température des composants. On s'arrange pour que le signal non-linéaire ainsi élaboré soit additionné au signal utile en opposition de phase, pour annuler les non linéarités de l'amplificateur hyperfréquence de puissance (non montré), mais uniquement dans une bande de fréquence relativement étroite et dans une gamme de puissance d'entrée relativement réduite, et à une température donnée.

En jouant sur les caractéristiques des organes correcteurs on peut obtenir une fonction de transfert dont le gain et la phase augmentent avec le niveau du signal d'entrée. Ceci est généralement la réponse recherchée lorsque l'on souhaite linéariser un TOP de puissance.

Un autre réglage des organes correcteurs permet d'obtenir une fonction de transfert dont le gain augmente avec le niveau du signal d'entrée mais dont la phase diminue avec celui-ci. Il s'agit dans ce cas de la réponse recherchée lorsque l'on souhaite linéariser un amplificateur de puissance à l'état solide.

Un autre linéariseur hyperfréquence large bande est décrit dans l'article de A.M. KHILLA, "Novel Broadband Linearizers and their application in poweramplifiers for satellite transponders and ground stations", Paru dans Proceedings Second European Conférence on Satellite Communications, Liege, Belgium, 22-24 October 1991 pp 229-234, publié par ESA (L'agence Spatiale Européenne), publication no. SP-332, article qui fait partie intégrante de la présente demande pour sa description de l'art antérieur.

Ce document enseigne l'utilisation d'un circuit de prédistorsion afin de linéariser un amplificateur large bande de transpondeur spatial en bande Ku. Comme dans le document de SATO et al., le circuit aurait deux branches, connectées à leurs extrémités par deux coupleurs 3dB hybride, chacun introduisant un déphasage de 90°. Il enseigne en outre l'utilisation de longueurs électriques équivalentes dans les deux branches, une configuration assez rare dans les autres circuits de prédistorsion décrits par ailleurs dans la littérature.

Le principe des linéariseurs à prédistorsion illustré par les documents de l'art antérieur cités ci-dessus convient pour les applications hyperfréquences. Il présente cependant plusieurs inconvénients majeurs qui rendent sa mise en oeuvre difficile. On peut en citer parmi d'autres :

- un premier inconvénient réside dans le fait que les opérations de réglage initial des circuits correcteurs de la caractéristique amplitude-fréquence et du correcteur de la caractéristique phase-fréquence, sont souvent longues et délicates à réaliser, tâche compliquée d'avantage dans le cas habituel ou les longueurs électriques des deux voies sont généralement très différentes ;

- un deuxième inconvénient des dispositifs de l'art antérieur est que la largeur de bande de fonctionnement optimal du dispositif correcteur de non-linéarités est en fait limitée par les différences ou par des variations différentielles des longueurs électriques des deux voies, soit en fonction de la fréquence ou de l'amplitude des signaux à amplifier, soit en fonction des conditions de fonctionnement dont notamment la température.

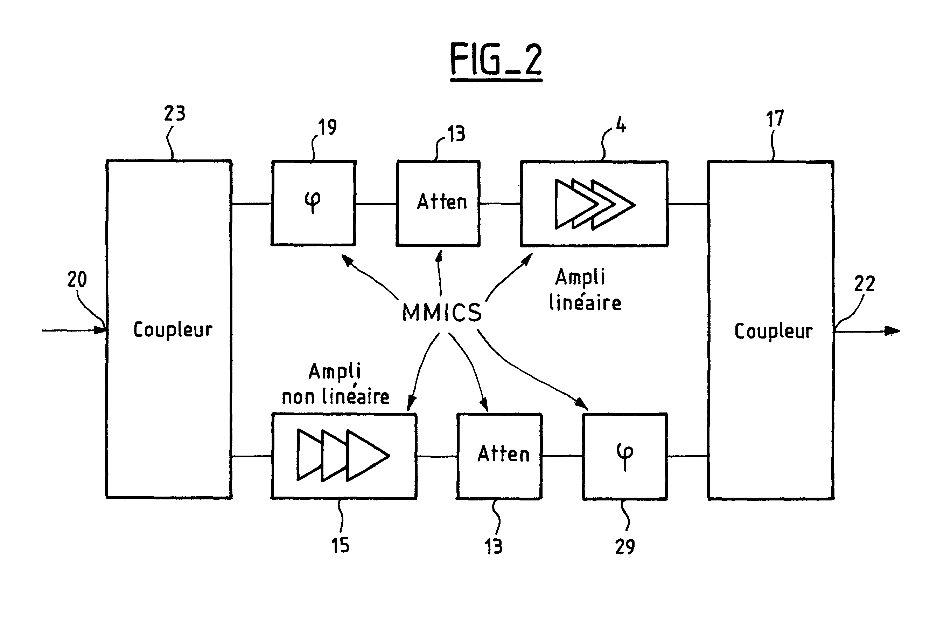

Dans le brevet français FR 2 719 954 et son equivalent US 5 576 660 au nom de POUYSEGUR, ces problèmes ont été adressés avec un linéariseur tel que montré sur la figure 2. Ce linéariseur a deux voies de longueur électrique sensiblement identiques comme le linéariseur de KHILLA mentionné ci-dessus. Une autre particularité de ce linéariseur est que les deux voies comportent des composants identiques pour éviter des derives d'une voie par rapport à l'autre en cas de variation de temperature. En revanche, ce linéariseur n'est efficace que sur une bande de fréquences relativement étroite.

Dans un autre brevet des mêmes inventeurs que la présente demande, le FR 2 791 197 équivalent au EP 1 039 630 A1, il est enseigné un linéariseur à large bande de fréquences qui fonctionne sur 1.5 GHz de bande en bande Ku, mais malheureusement, cette invention nous semble difficilement transposable, en technologie hybride, à la bande Ka. L'un des buts de la présente invention est donc de proposer un linéariseur large bande, pouvant être utilisé dans tous les différentes bandes de fréquences utilisées couramment sur les satellites de télécommunications, a savoir la bande C, Ku, et prochainement, la bande Ka.

Mise à part cette dernière réalisation, les dispositifs de pré-distorsion connus jusqu'à présent qui peuvent être utilisés pour des applications spatiales ne fonctionnent correctement que pour des bandes de fréquences de valeurs relativement faibles, par exemple de 250 à 500 MHz, dans une gamme de fréquences comprise entre 10,7 et 12,75 GHz.

On connaît par ailleurs, comme mentionné ci-dessus, quelques dispositifs de linéarisation pour des tubes amplificateurs qui peuvent fonctionner sur une large bande de fréquences, notamment une bande de 1,5 à 2 GHz en bande Ku. Toutefois, ces dispositifs connus présentent des structures complexes faisant appel à plusieurs circuits intégrés hyperfréquences. Leur réglage est délicat et ils sont sensibles à la température. En outre, ils sont, en général, d'un prix élevé et sont encombrants, ce qui constitue un inconvénient grave pour de nombreuses applications, notamment les applications spatiales. Et leur utilisation pour des hautes fréquences telles que la bande Ka autour de 20 GHz, semble difficile.

L'invention a pour but de pallier les inconvénients de l'art antérieur.

Le dispositif selon l'invention permet une linéarisation sur une large bande de fréquences. Il peut être réalisé à faible coût et par une technique de circuit intégré hyperfréquence. Et il peut être utilisé dans toutes les bandes de fréquences actuellement utilisées pour les télécommunications spatiales. Le réglage du circuit est aisé et reproductible, entraînant des économies de réalisation.

Le dispositif de linéarisation selon l'invention, qui fonctionne dans le domaine des hyperfréquences, est un linéariseur à pré-distorsion à large bande de fréquences du gain et de la phase d'un amplificateur de puissance fonctionnant dans le domaine des hyperfréquences comprenant des moyens pour conférer une pré-distorsion du gain et de la phase qui compense les non-linéarités en gain et en phase de l'amplificateur correspondant, ledit linéariseur comprenant en outre :

- un diviseur d'entrée comportant une entrée et deux sorties ;
- une première voie dite linéaire et une deuxième voie dite non-linéaire, lesdites voies linéaire et non-linéaire présentant par construction le même temps de propagation de groupe ; et
- un combineur de sortie ayant deux entrées et une sortie ;

caractérisé en ce que

- ladite voie non-linéaire comporte un élément non-linéaire large-bande comprenant un coupleur de Lange, dont deux accès sont reliés à la masse chacun à travers un élément actif ;
- ladite voie linéaire comporte un coupleur de Lange identique celui de la voie non-linéaire, dont deux accès sont reliés à la masse chacun à travers un élément passif.

Dans un mode de réalisation préféré, lesdits deux éléments actifs sont des diodes, dont la tension d'alimentation à travers une résistance en série permet d'ajuster la courbe d'extension de gain de la non-linéarité en fonction de la puissance incidente.

Selon un mode de réalisation lesdits deux éléments passifs sont des tronçons de lignes de transmission hyperfréquence (« stubs » en anglais) en circuit ouvert de longueur réglable, dont la longueur permet d'ajuster la phase relative entre les voies linéaire et non linéaire de façon constante sur toute la bande de fréquence réalisant ainsi la fonction déphaseur.

Selon un mode de réalisation, au moins une de ladite voie linéaire et ladite voie non-linéaire comporte une ligne de transmission de longueur réglable, afin de permettre, à partir d'un temps de propagation de groupe égale entre voie, de modifier ce paramètre, donc de régler la phase de recombinaison en fonction de la fréquence et par conséquent de régler de cette façon la réponse en fréquence du linéariseur pour compenser celle de l'amplificateur à linéariser

Selon un autre mode de réalisation, au moins une de ladite voie linéaire et ladite voie non-linéaire (préférentiellement la voie linéaire) comporte au moins une résistance gravée en série sur la ligne de transmission jouant le rôle d'un atténuateur dont la valeur est réglable entre une valeur finie et zéro en court-circuitant la résistance par un ruban ou au moins un fil métallique.

Selon un autre mode de réalisation préféré, ledit diviseur est un coupleur Wilkinson à 0° .

Selon un autre mode de réalisation préféré, ledit combineur est un coupleur Wilkinson à 0°.

D'autres caractéristiques et avantages de l'invention apparaîtront avec la description de certains de ses modes de réalisation, celle-ci étant effectuée en se référant aux dessins ci-annexés sur lesquels :

la figure 1, déjà décrite, est un schéma de principe d'un amplificateur de puissance et d'un dispositif linéariseur à pré-distorsion, avec les caractéristiques de puissance de sortie en fonction de la puissance d'entrée correspondantes à ces deux éléments en figures 1a et 1b, ainsi que la caractéristique résultante en figure 1c;

la figure 2 est un schéma d'un dispositif linéariseur à pré-distorsion connu de l'art antérieur et notamment par le brevet FR 2 719 954 équivalent à US 5 576 660 au nom de POUYSEGUR ;

la figure 3 est un schéma de principe d'un dispositif linéariseur à prédistorsion et à large bande de fréquences conforme à l'invention ;

la figure 4 est un schéma électrique d'un exemple d'une réalisation dispositif linéariseur à pré-distorsion et à large bande de fréquences conforme à l'invention ;

la figure 5 est un schéma d'implantation d'un exemple d'une réalisation d'un circuit physique d'un dispositif linéariseur à pré-distorsion et à large bande de fréquences conforme à l'invention ;

la figure 6 représente la phase de recombinaison entre la voie linéaire et la voie non-linéaire en fonction de la fréquence avec un déphaseur dans la première voie et un élément non linéaire dans la seconde voie, pour différentes valeurs électriques de l'élément passif chargeant la voie linéaire, d'un dispositif linéariseur à pré-distorsion et à large bande de fréquences conforme à l'invention ;

la figure 7 représente la phase de recombinaison entre la voie linéaire et la voie non-linéaire en fonction de la fréquence avec l'adjonction d'une longueur de ligne variable dans l'une ou l'autre des voies, d'un dispositif linéariseur à prédistorsion et à large bande de fréquences conforme à l'invention ;

la figure 8 montre le principe de réalisation d'une ligne de longueur variable avec une technologie hybride ;

la figure 9 montre des mesures de linéarisation de gain obtenues avec une réalisation expérimentale d'un linéariseur selon l'invention, placé avant un tube à ondes progressives, fortement non-linéaire ;

la figure 10 montre des mesures de linéarisation de phase obtenues avec une réalisation expérimentale du même linéariseur que la figure 9, devant le même tube à ondes progressives.

Les figures sont données à titre d'exemples non limitatifs pour illustrer les principales caractéristiques de l'invention et de ses variantes. Les mêmes repères se réfèrent aux mêmes éléments sur les différentes figures. L'échelle n'est pas toujours respectée pour des raisons de clarté. Des moyens équivalents peuvent être substitués aux éléments représentés sur les figures sans sortir pour autant du cadre de l'invention.

La figure 2 montre un exemple d'un linéariseur selon l'art antérieur. Comme dans la figure précédente, le signal à amplifier est présenté à l'entrée 20 du linéariseur, d'où il est appliqué à l'entrée d'un coupleur diviseur de puissance 23. Le signal est ainsi divisé en deux parties, qui sont appliquées respectivement aux entrés de deux lignes de transmission. Classiquement, le coupleur- diviseur 23 introduit un décalage de phase θ entre les deux signaux fournis en sortie vers les deux lignes de transmission. Ce coupleur 23 peut être par exemple un coupleur hybride 3 dB, ce qui introduit un déphasage de θ = π/2 (=90°).

La première ligne de transmission (dite la voie non-linéaire) comprend un amplificateur 15, générateur d'une distorsion non-linéaire d'amplitude de même nature que celle de l'amplificateur de puissance que l'on voudrait linéariseur, un atténuateur variable 13, et un déphaseur variable 29.

Sur la deuxième ligne de transmission (dite la voie linéaire), nous avons également un déphaseur variable 19, un atténuateur variable 13, et un amplificateur hyperfréquence 4.

Les signaux sur les deux voies sont ensuite additionnés par un coupleur combineur 17. Le signal de correction par prédistorsion est fourni en sortie 22 du coupleur combineur 17. Le signal de correction par prédistorsion est fourni en sortie 22 du coupleur combineur 17 à un amplificateur hyperfréquence de puissance (non montré). Classiquement, le coupleur combineur 17 introduit un décalage de phase phase θ entre les deux signaux fournis en sortie vers les deux lignes de transmission. Ce coupleur 17 peut être par exemple un coupleur hybride 3 dB, ce qui introduit un déphasage de θ = π/2 (=90°).

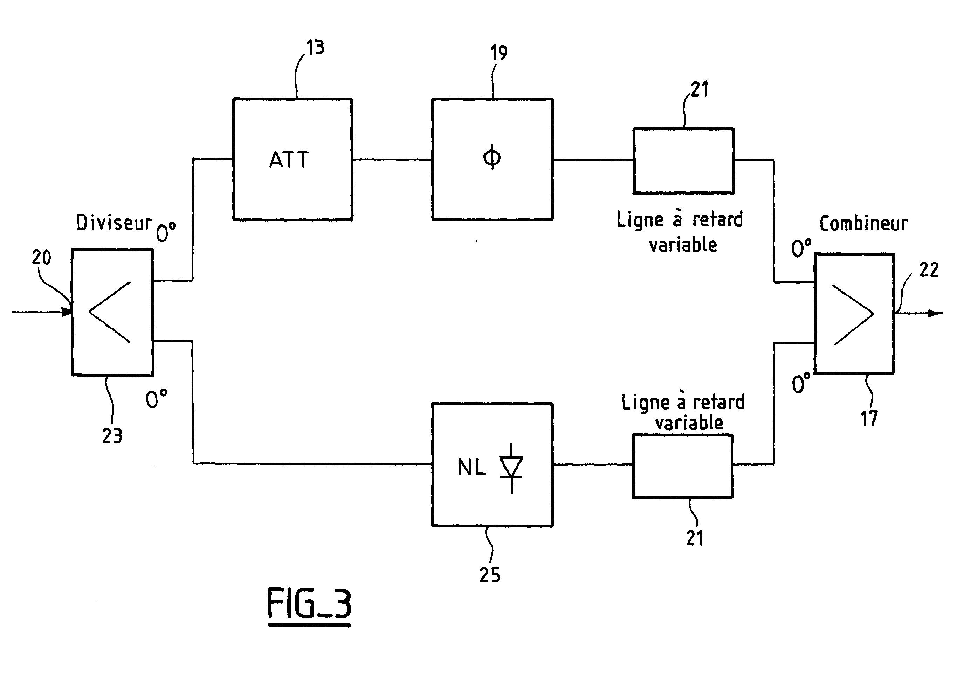

La figure 3 est un schéma de principe d'un dispositif linéariseur à prédistorsion et à large bande de fréquences conforme à l'invention. L'architecture de la figure 3 s'appuie sur des principes connus tels que :

- la recombinaison vectorielle d'une voie linéaire et d'une voie non linéaire,

- l'utilisation d'atténuateurs 13, de déphaseurs 19, d'une non linéarité 25 et éventuellement de lignes à retard 21,

- le fait d'avoir les mêmes temps de propagation de groupe entre les 2 voies sur une bande de fréquence donnée.

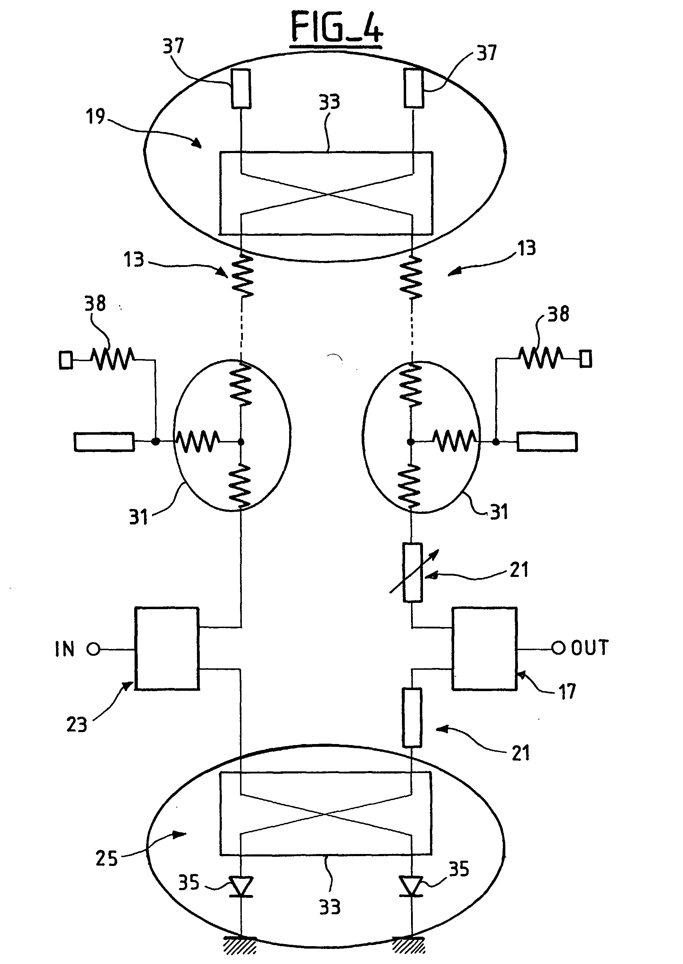

Les différences avec l'art antérieur seront plus facilement appréciées en se référant à la figure 4, qui montre un schéma électrique d'un exemple d'une réalisation d'un dispositif linéariseur à pré-distorsion et à large bande de fréquences conforme à l'invention.

Comme dans le schéma précédent, on a les deux voies linéaire et non-linéaire entre deux coupleurs, un diviseur de puissance 23 et un combineur de puissance 17. La voie non-linéaire est en bas comme dans la figure précédente. Dans une réalisation préférée, il y a une ligne à retard 21 de longueur variable dans l'une ou l'autre des deux voies, ici il y en a une dans chaque

9 **EP 1 320 190 B1** 10

voie. Leur utilité sera expliqué ci-après. Différents atténuateurs 13, 31 sont montrés de préférence sur la voie linéaire mais peuvent être également placé sur la voie non linéaire ; ceux-ci facilitent certains réglages en usine.

Parmi les originalités caractéristiques de l'invention, on remarque sur les deux voies :

- la voie linéaire intégrant principalement un déphaseur 19 constitué d'un coupleur de Lange 33 dont deux accès sont reliés à la masse par un tronçon de ligne 37 dont l'une des extrémités est en circuit ouvert ;

- la voie non linéaire intégrant principalement un dispositif réalisant une expansion de gain en fonction de la puissance incidente, ce dispositif étant constitué d'un coupleur de Lange 33 identique à la voie linéaire dont deux accès sont reliés à la masse par un élément actif 35. Dans une réalisation préférée cet élément actif est une diode. De préférence, les deux diodes 35 seront identiques.

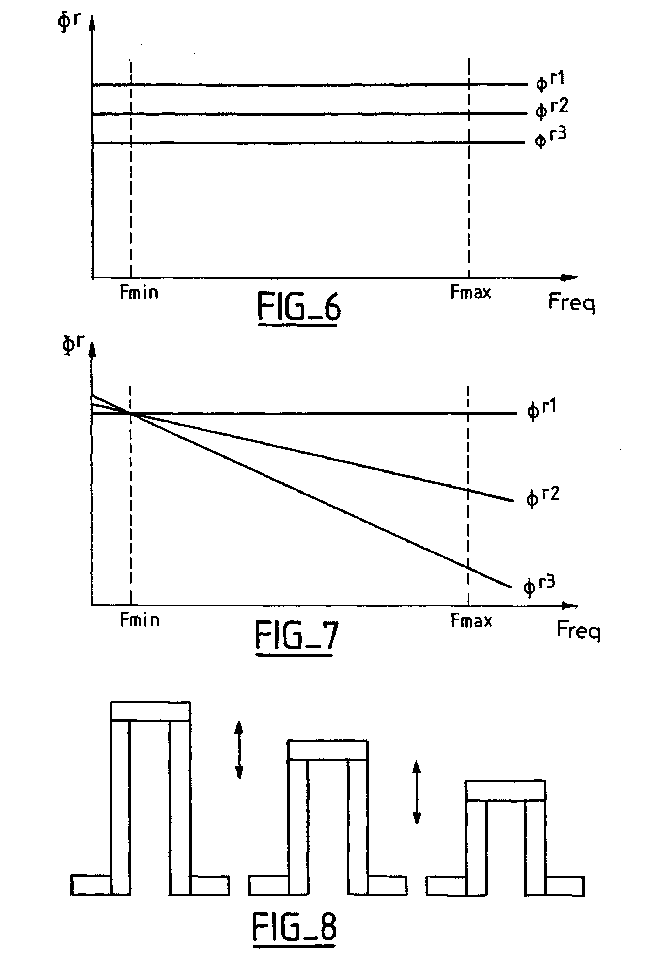

La mise en regard de ces 2 dispositifs permet aux voies linéaire et non linéaire d'avoir, par construction, le même temps de propagation de groupe sur toute la bande de fréquence de fonctionnement du déphaseur et de l'élément non linéaire. La phase de recombinaison φr des 2 voies est donc constante sur toute la bande considérée, la réponse du linéariseur ainsi réalisé est aussi constante sur la même bande. Le résultat est montré sur la figure 6.

Lesdits « stubs » sont de longueur variable, ce qui permet de contrôler la phase de recombinaison φr1, φr2, φr3... et de faire varier la réponse du linéariseur de façon uniforme sur toute la bande de fréquence (extension ou compression de gain et/ou de phase). Le résultat est aussi montré sur la figure 6.

Dans l'exemple de réalisation préférée montrée sur la figure 4, les diodes 35 de l'élément non linéaire 33 sont polarisées à travers une résistance de forte valeur 38. Le principe est de réaliser avec ces diodes 35 une impédance augmentant avec la puissance incidente. Le coupleur de Lange 33 sera chargé à bas niveau par une impédance faible et aura de fortes pertes. L'impédance augmentant, les pertes du coupleur de Lange vont diminuer, générant par la même l'expansion de « gain » souhaitée. On se polarise donc au départ (à bas niveau) dans la caratéristique I(V) de la diode correspondant à une impédance faible. La puissance incidente hyperfréquence va générer un courant augmentant avec cette puissance. Ce courant à travers la résistance va générer une tension qui va autopolariser la diode en dehors de sa caractéristique de conduction faisant passer sont impédance équivalent d'une faible à une forte valeur. Le réglage de la tension alimentant la diode à travers la résistance va permettre de régler l'expansion de gain de l'élément non linéaire, « moteur » du linéariseur.

L'adjonction d'une ligne de transmission de longueur variable 21 dans l'une ou/et l'autre des voies a pour but, à partir de voies déjà équilibrées par construction, de faire varier la phase de recombinaison φr et donc la réponse du linéariseur en fonction de la fréquence. Le réglage est très simple dans la mesure ou il ne fait intervenir que la longueur de la ligne :

$$\Delta\phi r(f) = \beta l = 2\pi f l/c$$

avec

f : fréquence
c : $3.10^8$m/s
l : longueur de la ligne

Le résultat est montré sur la figure 7. La phase de recombinaison entre la voie linéaire et la voie non-linéaire est une fonction linéaire de la fréquence dans la bande utile du linéariseur, dont la pente est déterminée par la longueur de la ligne de longueur variable 21.

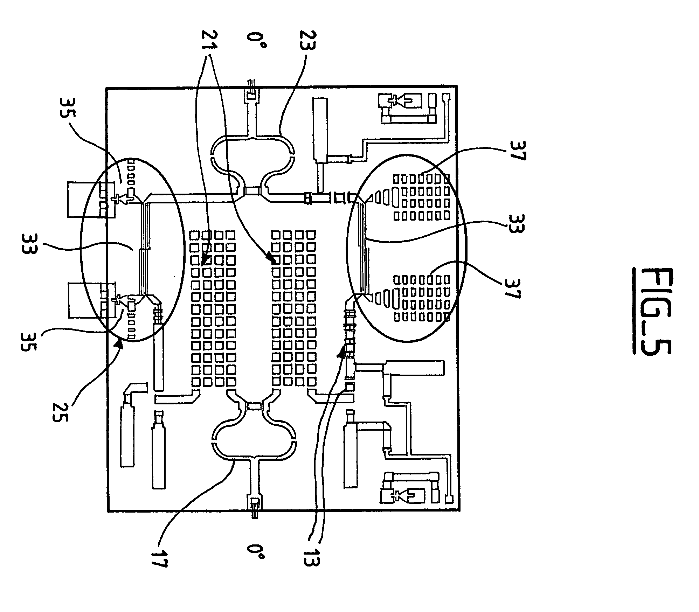

La réalisation d'une ligne à longueur variable est aisée, telle que montré sur le schéma d'implantation de la figure 5, et explicitée a l'aide de la figure 8. Des plots métalliques sont gravés sur le substrat dans un réseau rectangulaire. La longueur de la ligne peut alors être choisie en connectant les plots. Plus de plots donne une longueur plus longue. Un principe similaire peut être avantageusement utilisé pour la réalisation des déphaseurs variables 37.

D'une manière similaire, des atténuateurs variables peuvent être réalisés en gravure. Afin de ne pas dégrader l'équilibrage des TPG des 2 voies, le réglage de l'amplitude relative des signaux avant recombinaison est réalisé avec des atténuateurs gravés. Ce sont des tronçons de lignes en série sur la ligne de transmission utilisant un métal résistifs. La phase d'insertion de ce petit dispositif est homogène à celui d'une simple ligne et ne dégrade donc pas le TPG. Plusieurs de ces atténuateurs sont insérés sur la ligne est peuvent être court-circuités par un ruban métallique pour réaliser le réglage. De façon préférentielle, ces atténuateurs sont implantés sur la voie linéaire pour minimiser les pertes du linéariseur, l'élément non linéaire devant lui fonctionner avec une puissance d'entrée donnée.

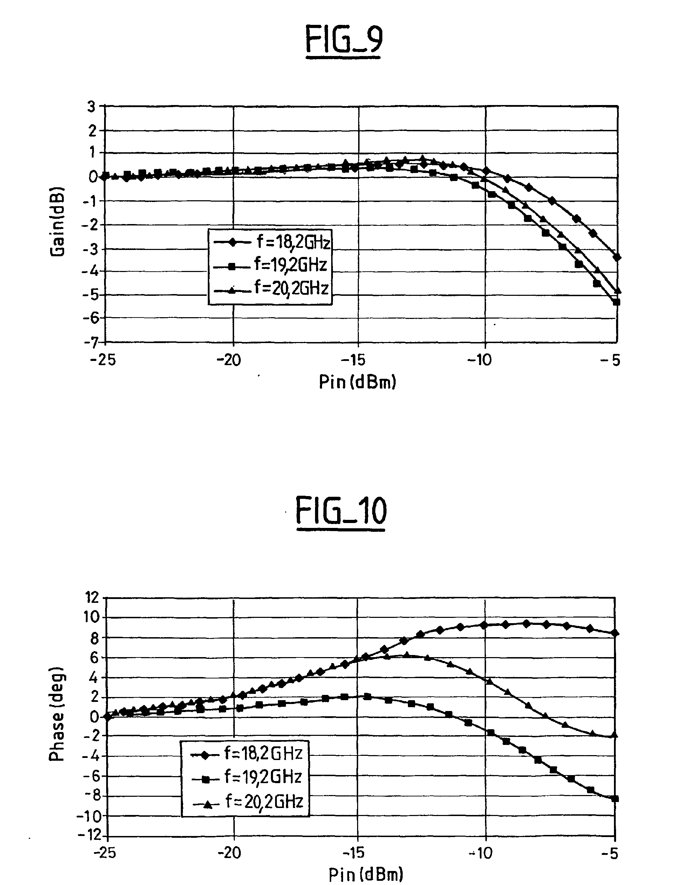

La figure 9 montre des mesures de linéarisation de gain obtenues avec une réalisation expérimentale d'un linéariseur selon l'invention, placé avant un tube à ondes progressives (TOP), assez fortement non-linéaire à saturation. Le TOP fournit 120 W en bande Ka entre18.2 et 20.2 Ghz. Le TOP fonctionnant en saturation donne une compression de gain de 7 à 6,7 dB, et -30° à -45 ° de décalage de phase dans cette même bande de fréquences. Les courbes de la figure 9 montrent une excellente linéarité de +/- 1 dB dans la région non-saturée (inférieur à -10 dBm), avec une perte de seulement 5 à 6 dB de bain à saturation.

La figure 10 montre des mesures de linéarisation de phase obtenues avec une réalisation expérimentale du même linéariseur que la figure 9, devant le même tube à ondes progressives. On constate que le décalage de phase est inférieur à +/- 10 degrés sur toute la bande de fréquences, et pour toute puissance a l'entrée entre -25 et -5 dBm. Ces chiffres sont a comparer avec les chiffres du TOP tout seul donnés ci-dessus : -30° à -45° de décalage à - 10 dBm, allant jusqu'à -40 à-70 degrés à 5 dBm, le pire étant pour les plus hautes fréquences (20,2 GHz).

Bien entendu, l'invention n'est pas limitée aux exemples discutés et décrits ci-dessus, mais peut s'appliquer à toutes les réalisations utilisant un ou plusieurs moyen(s) équivalent(s) au moyens décrits à titre d'exemple, pour remplir les mêmes fonctions, en vu d'obtenir les mêmes résultats.

## Revendications

1. Linéariseur à pré-distorsion à large bande de fréquences du gain et de la phase d'un amplificateur de puissance fonctionnant dans le domaine des hyperfréquences comprenant des moyens pour conférer une pré-distorsion du gain et de la phase qui compense les non-linéarités en gain et en phase de l'amplificateur correspondant, ledit linéariseur comprenant en outre :

   - un diviseur d'entrée (23) comportant une entrée (IN) et deux sorties ;
   - une première voie dite linéaire et une deuxième voie dite non-linéaire, lesdites voies linéaire et non-linéaire présentant par construction le même temps de propagation de groupe ; et
   - un combineur de sortie (17) ayant deux entrées et une sortie (OUT),
   - Ladite voie non-linéaire comportant un élément non-linéaire large-bande comprenant un coupleur de Lange (25, 33), dont deux accès sont reliés à la masse chacun à travers un élément actif (35),
   - Ladite voie linéaire comportant un coupleur de Lange (19, 33) identique celui de la voie non-linéaire, dont deux accès sont reliés à la masse chacun à travers un élément passif (37);
   - **caractérisé en ce que** lesdits deux éléments passifs (37) sont des tronçons de lignes de transmission hyperfréquence dont l'une des extrémités est en circuit ouvert de longueur réglable, dont la longueur permet d'ajuster la phase relative entre les voies linéaire et non linéaire de façon constante sur toute la bande de fréquence réalisant ainsi la fonction déphaseur et **en ce qu'**au moins une de ladite voie linéaire et ladite voie non-linéaire, préférentiellement la voie linéaire, comporte au moins une résistance gravée en série sur la ligne de transmission jouant le rôle d'un atténuateur (31) dont la valeur est réglable entre une valeur finie et zéro en court-circuitant la résistance par un ruban ou au moins un fil métallique, et **en ce qu'**au moins une de ladite voie linéaire et ladite voie non-linéaire comporte une ligne de transmission de longueur réglable (21), afin de permettre, à partir d'un temps de propagation de groupe égale entre voie, de modifier ce paramètre, donc de régler la phase de recombinaison en fonction de la fréquence et par conséquent de régler de cette façon la réponse en fréquence du linéariseur pour compenser celle de l'amplificateur à linéariser.

2. Linéariseur selon la revendication 1, **caractérisé en ce que** lesdits deux éléments actifs (35) sont des diodes, dont l'impédance augmente avec une puissance incidente, les pertes du coupleur de Lange diminuant, générant par la même la courbe d'extension de gain de la non-linéarité en fonction de la puissance incidente.

3. Linéariseur selon la revendication 1, **caractérisé en ce que** ledit diviseur (17) est un coupleur Wilkinson à 0°.

4. Linéariseur selon la revendication 1, **caractérisé en ce que** ledit combineur (17) est un coupleur Wilkinson à 0°.

## Claims

1. Wide frequency band predistorsion linearizer of the gain and of the phase of a power amplifier operating in the microwave region comprising means for imparting a predistorsion of the gain and of the phase which compensates for the non-linearities in gain and in phase of the corresponding amplifier, the said linearizer furthermore comprising:

   - an input divider (23) comprising an input (IN) and two outputs;
   - a first pathway termed linear and a second pathway termed non-linear, the said linear and non-linear pathways exhibiting by construction the same group propagation time; and
   - an output combiner (17) having two inputs and an output (OUT);
   - The said non-linear pathway comprising a wide-band non-linear element comprising a Lange coupler (25,33), two of whose ports are earthed, each through an active element (35);
   - The said linear pathway comprising an identical Lange coupler (12, 33) to that of the non-linear pathway, two of whose ports are earthed, each through a passive element (37);

- **characterized in that** the said two passive elements (37) are stretches of microwave transmission lines, one of the ends of which is in open circuit of adjustable length, the length of which makes it possible to adjust the relative phase between the linear and non-linear pathways in a constant manner over the whole frequency band thus achieving the phase shifter function and **in that** at least one of the said linear pathway and the said non-linear pathway, preferably the linear pathway, comprises at least one etched resistor in series on the transmission line playing the role of an attenuator (31) whose value is adjustable between a finite value and zero by short-circuiting the resistor by a strip or at least one metal wire, and **in that** at least one of the said linear pathway and the said non-linear pathway comprises a transmission line of adjustable length (21), so as to make it possible, on the basis of an equal inter" pathway group propagation time, to modify this parameter, therefore to adjust the recombination phase as a function of frequency and consequently to adjust in this way the frequency response of the linearizer so as to compensate for that of the amplifier to be linearized.

2. Linearizer according to Claim 1, **characterized in that** the said two active elements (35) are diodes, whose impedance increases with incident power, the losses of the Lange coupler decreasing, thereby generating the gain extension curve for the nonlinearity as a function of incident power.

3. Linearizer according to Claim 1, **characterized in that** the said divider (17) is a 0º Wilkinson coupler.

4. Linearizer according to Claim 1, **characterized in that** the said combiner (17) is a 0º Wilkinson coupler.

**Patentansprüche**

1. Breitfrequenzband-Vorverzerrungslinearisierer der Verstärkung und der Phase eines im Bereich der Höchstfrequenzen arbeitenden Leistungsverstärkers, der Mittel aufweist, um eine Vorverzerrung der Verstärkung und der Phase zu verleihen, die die Nichtlinearitäten der Verstärkung und der phase des entsprechenden Verstärkers kompensiert, wobei der Linearisierer außerdem aufweist:

- einen Eingangsteiler (23), der einen Eingang (IN) und zwei Ausgänge aufweist;
- einen ersten so genannten linearen Kanal und einen zweiten so genannten nicht-linearen Kanal, wobei der lineare und der nicht-lineare Kanal bauartbedingt die gleiche Gruppenausbreitungszeit aufweisen; und
- einen Ausgangskombinierer (17) mit zwei Eingängen und einem Ausgang (OUT),
- wobei der nicht-lineare Kanal ein nichtlineares Breitbandelement aufweist, das einen Lange-Koppler (25, 33) aufweist, von dem zwei Zugänge je über ein aktives Element (35) mit Masse verbunden sind,
- wobei der lineare Kanal einen Lang-Koppler (19, 33) gleich demjenigen des nicht-linearen Kanals aufweist, von dem zwei Zugänge je über ein passives Element (37) mit Masse verbunden sind;
- **dadurch gekennzeichnet, dass** die zwei passiven Elemente (37) Abschnitte von Hochfrequenzübertragungsleitungen sind, deren eines Ende in offenem Stromkreis mit einstellbarer Länge ist, dessen Länge es ermöglicht, die relative Phase zwischen dem linearen und dem nicht-linearen Kanal konstant über das ganze Frequenzband einzustellen, wodurch die Phasenschieberfunktion hergestellt wird, und dass mindestens einer, der lineare Kanal oder der nicht-lineare Kanal, vorzugsweise der lineare Kanal, mindestens einen Widerstand aufweist, der in Reihe auf die Übertragungsleitung geätzt wird und die Aufgabe eines Dämpfungsglieds (31) übernimmt, dessen Wert durch Kurzschließen des Widerstands durch ein Band oder mindestens einen Metalldraht zwischen einem endlichen Wert und Null einstellbar ist, und dass mindestens einer, der lineare Kanal oder der nicht-lineare Kanal, eine Übertragungsleitung mit einstellbarer Länge (21) aufweist, um es ausgehend von einer gleichen Gruppenausbreitungszeit zwischen Kanal zu erlauben, diesen Parameter zu verändern, also die Rekombinationsphase in Abhängigkeit von der Frequenz zu regeln und folglich auf diese Weise die Frequenzantwort des Linearisierers zu regeln, um diejenige des zu linearisierenden Verstärkers zu kompensieren.

2. Linearisierer nach Anspruch 1, **dadurch gekennzeichnet, dass** die zwei aktiven Elemente (35) Dioden sind, deren Impedanz mit einer einfallenden Leistung ansteigt, während die Verluste des Lange-Kopplers abnehmen, wodurch die Verstärkungserweiterungskurve der Nichtlinearität in Abhängigkeit von der einfallenden Leistung erzeugt wird.

3. Linearisierer nach Anspruch 1, **dadurch gekennzeichnet, dass** der Teiler (17) ein 0°-Wilkinson-Koppler ist.

4. Linearisierer nach Anspruch 1, **dadurch gekennzeichnet, dass** der Kornbinierer (17) ein 0°-Wilkin-

son-Koppler ist.

## FIG_1

## FIG_1a

## FIG_1b

## FIG_1c

# FIG_2

23    19    13    4    17

20

Coupleur

φ    Atten    ▷▷▷

Ampli
linéaire

MMICS

Ampli
non linéaire

▷▷▷    Atten    φ

Coupleur

22

15    13    29

EP 1 320 190 B1

EP 1 320 190 B1

FIG_3

12

## FIG_4

# FIG_5

FIG_6

FIG_7

FIG_8

## FIG_9

## FIG_10

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4992754 A
- US 4068186 A
- FR 2719954
- US 5576660 A
- FR 2791197
- EP 1039630 A1

**Littérature non-brevet citée dans la description**

- **A.M. KHILLA.** Novel Broadband Linearizers and their application in poweramplifiers for satellite transponders and ground stations. *Paru dans Proceedings Second European Conférence on Satellite Communications,* 22 Octobre 1991, 229-234